# FASCICULE DE BREVET EUROPEEN

(11) **EP 3 326 197 B1**
(45) Date de publication et mention de la délivrance du brevet: **24.07.2019**
(21) Numéro de dépôt: 16742349.0
(22) Date de dépôt: 29.06.2016
(51) Int. Cl.: H01L 21/20, H01L 21/02, H01L 23/00

(54) **PROCÉDÉ DE COLLAGE DIRECT**
DIREKTBINDUNGSVERFAHREN
DIRECT BONDING METHOD

(30) Priorité: 24.07.2015 FR 1557117
(43) Date de publication de la demande: 30.05.2018
(73) Titulaire: Commissariat à l'Énergie Atomique et aux Énergies Alternatives, 75015 Paris (FR)
(72) Inventeur: GONDCHARTON, Paul, 38100 Grenoble (FR); BENAISSA, Lamine, 91300 Massy (FR); IMBERT, Bruno, 38000 Grenoble (FR); RODRIGUEZ, Guillaume, 38190 Le Champ Pres Froges (FR); SABBIONE, Chiara, 14100 Asti (IT)
(74) Mandataire: Delorme, Nicolas
(86) Numéro de dépôt international: PCT/FR2016/051621
(87) Numéro de publication internationale: WO 2017/017325

(56) Documents cités:
- WO-A1-2014/195621
- US-A1- 2012 241 821

## Description

La présente invention concerne un procédé de collage direct entre un premier substrat et un deuxième substrat et en particulier un procédé de collage conducteur électrique entre des couches de collage à base de tungstène et d'oxyde de tungstène.

La technique du collage direct est utilisée dans différents domaines de la microélectronique : l'intégration 3D à haute-densité d'interconnexions, le packaging de composants MEMS ou NEMS (Micro ou Nano Electrical Mechanical Systems) ou encore dans le report de composants de silicium sur des substrats particuliers tels que des embases métalliques, des substrats III-V ou des substrats pour les applications RF (Radiofréquence).

A l'heure actuelle deux principales approches d'intégration dans le domaine de l'intégration 3D sont connues. Dans une première approche hétérogène, les composants sont fabriqués séparément sur deux substrats différents. La fabrication comprend toutes les étapes jusqu'aux derniers niveaux d'interconnexions dits *back-end*. Les substrats sont ensuite assemblés par collage direct des surfaces mixtes de matériaux diélectriques et de métaux (SiO₂/Cu). La limitation principale de cette approche est l'alignement nécessaire lors du collage qui doit être inférieure à 1 µm ce qui est difficilement réalisable à l'échelle industrielle. Une autre limitation réside en ce que la résistivité du cuivre augmente de façon significative pour les films minces et les interconnexions fines. Dans la seconde approche séquentielle, un premier substrat est préparé jusqu'aux niveaux *middle-end* d'interconnexions (plugs de tungstène). On reporte alors sur ce substrat une couche mince semi-conductrice par exemple par Smart Cut™ ou amincissement mécanique d'un deuxième substrat. Des composants sont alors préparés dans cette couche fine transférée et peuvent être alignés avec ceux du substrat inférieur avec une précision lithographique d'environ 50 nm. Puisque le procédé de collage se fait au niveau *middle-end*, le collage direct est avantageusement réalisé sur des couches minces de tungstène, dont la conductivité est supérieure à celle du cuivre. Ces couches de tungstène servent à la fois de lien mécanique et électrique entre les deux couches actives.

Toutefois, le collage direct de couches minces de tungstène constitue un challenge technologique majeur. En effet, la gestion des produits de réaction (suite notamment à un recuit de consolidation après collage) provoque une défectivité très importante du fait de la nature même des espèces chimiques mises en contact. Le procédé étant réalisé à l'air ambiant, il y a formation d'un oxyde natif sur les couches métalliques mises en jeu. Cet oxyde natif est instable avec l'apport de budgets thermiques après collage. Le collage de cette phase d'oxyde n'assure donc pas un assemblage de qualité, l'assemblage présente une faible tenue mécanique, une forte défectivité et une faible conduction électrique verticale.

Afin de remédier à ces problèmes, deux approches principales ont été développées. L'une consiste à effectuer le collage sous ultravide après décapage de la surface des couches minces de tungstène par bombardement ionique afin de retirer son oxyde natif. En effet, suite à ce bombardement, des liaisons pendantes sont disponibles et le contact métal-métal est alors possible. Cependant cette solution est très sensible puisqu'elle est réalisée sous ultravide, elle reste donc difficilement commercialisable à un coût abordable.

Une autre méthode consiste au collage direct de couches de tungstène déposées par CVD (de l'acronyme anglo-saxon « Chemical Vapor Deposition ») après une étape de polissage mécanique et chimique, également connue sous l'acronyme anglo-saxon CMP (Chemical Mechanical Polishing). Néanmoins, un inconvénient d'un tel procédé réside dans le fait qu'il requiert la formation d'une sous-couche d'accroche pour la germination et la formation d'une couche de tungstène stable par dépôt CVD. Cette sous-couche d'accroche, couramment en TiN, entraîne une réduction de la conductivité électrique verticale de l'ensemble. Un autre inconvénient d'un tel procédé réside dans le fait que l'énergie de collage obtenue est faible à température ambiante. Seules des températures de recuit du collage supérieures à 700°C permettent de sceller le collage, ce qui ne peut être utilisé dans le cadre de l'intégration 3D ou d'autres méthodes dans lesquels les substrats comportent des composants électroniques sensibles à la température.

Une solution décrite dans le document FR1455848 a dernièrement été développée afin de remédier aux inconvénients précités. Cette méthode consiste en un dépôt d'une phase maîtrisée d'oxyde de tungstène par reactive-sputtering, c'est-à-dire par pulvérisation réactive en injectant directement du dioxygène gazeux dans un plasma d'argon initialement établi dans la chambre de dépôt de pulvérisation du tungstène. En contrôlant finement la stoechiométrie de l'oxyde de tungstène déposé dit de passivation, sur une couche de tungstène, il a été montré que l'assemblage de deux couches de tungstène était possible sans défectivité au niveau de l'interface de collage jusqu'à 1200°C, avec une forte tenue mécanique, notamment compatible avec le procédé Smart Cut™, et une bonne conduction électrique verticale. On entend ici par défectivité, la création de défauts à l'interface de collage avec le traitement thermique post-collage de diamètre supérieur à 10 µm détectable par la technique SAM en acronyme anglo-saxons (Scanning Acoustic Microscopy).

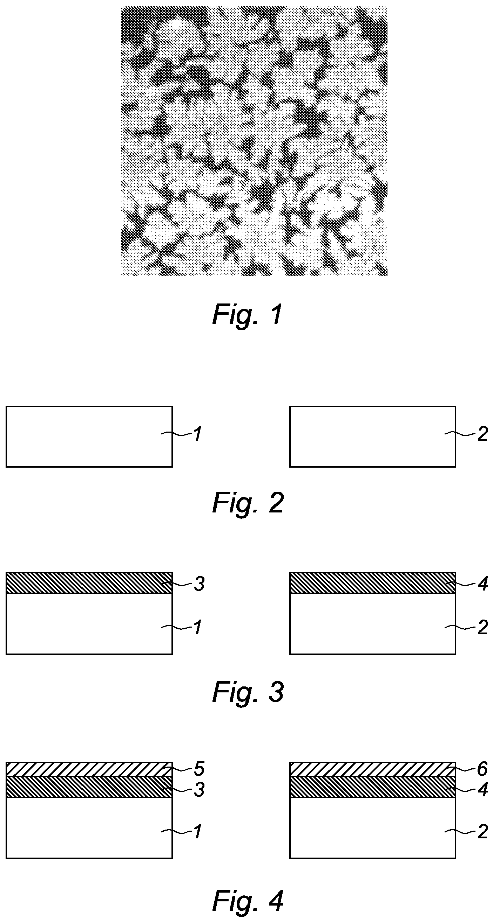

Cependant une réaction de cristallisation suivant une croissance dendritique de ces couches d'oxyde de tungstène vers des températures de 500°C affecte l'intégrité et la continuité de la couche et compromet leur intégration. La figure 1 reproduit un scan réalisé par AFM (acronyme anglo-saxon pour microscopie à force atomique) sur un champ de 4 micromètres x 4 micromètres d'une telle couche recuite pendant 2 heures. Des cristaux de taille importante (partie la plus claire) sont formés, la formation de ces cristaux peuvent conduire à générer des vides de matière dans la couche, rendant la conduction électrique verticale localement impossible à travers celle-ci. ≦

US2012/0241821 décrit un support pour la réalisation d'une hétérostructure pour la fabrication de composants électroniques de puissance ou de composants optoélectroniques, ou de composants photovoltaïques comprenant successivement de sa base vers sa surface : - un substrat support, - une couche de collage, - une couche monocristalline, sans fissure, dite « couche active » d'un matériau de composition AlₓIn_{y}Ga_{(1-x-y)}N, où 0≦x≦1, 0≦y≦1 et x+y≦1, présentant une épaisseur comprise entre 3 et 100 micromètres, dans laquelle ou sur laquelle seront fabriqués les composants de puissance.

Un des buts de la présente invention est ainsi de pallier au moins l'un de ces inconvénients. A cet effet, la présente invention propose un procédé de collage direct entre un premier substrat et un deuxième substrat, notamment utilisés dans l'industrie de la microélectronique, le procédé comprenant les étapes de :
a) Fournir le premier substrat et le deuxième substrat,
b) Former une première couche de collage à base d'oxyde de tungstène sur le premier substrat et une deuxième couche de collage à base d'oxyde de tungstène sur le deuxième substrat, l'une au moins parmi la première couche de collage et la deuxième couche de collage comportant, un troisième élément M de sorte à former un alliage de type MWxOy, le teneur atomique de M dans la composition étant comprise entre 0.5 et 20% et de préférence comprise entre 1 et 10%,
c) Procéder au collage direct entre la première couche de collage et la deuxième couche de collage, et
d) Réaliser un traitement thermique à une température supérieure à 250°C, et avantageusement à une température comprise environ entre 400 et 600°C.

Grâce à cette configuration, l'oxyde de tungstène généralement instable est stabilisé par l'apport d'un troisième élément M formant un alliage résistant à la température. Ainsi, l'intégrité de la première couche collage et de la deuxième couche de collage résiste au traitement thermique servant à augmenter l'énergie collage entre le premier et le deuxième substrat. Aucune discontinuité n'apparaît dans lesdites couches. Ainsi, les deux substrats sont collés par un collage direct conducteur électrique grâce à la conduction électrique verticale assurée par les couches de collages. L'absence de lacune dans la couche de collage, par comparaison aux méthodes précédemment décrites, permet de réaliser des connexions fiables, même à partir de connecteurs (plugs) en tungstène de petites tailles (50 nm). De plus, la température du traitement thermique de recuit de collage est peu élevée de sorte que les éventuels composants électroniques sur les substrats sont préservés.

Avantageusement à partir 250°C, le traitement thermique de l'étape c) apporte un renforcement de collage suffisant pour atteindre un niveau d'adhésion compatible avec un amincissement mécanique ou un procédé Smart Cut™ à basse température, notamment obtenu par co-implantation d'espèces ioniques.

Une température de consolidation comprise entre 400 et 600°C permet d'accéder à un niveau d'adhésion compatible avec des conditions « classiques » de Smart Cut™ (une espèce ionique implantée, température de fracture autour de 500°C).

Par l'expression 'collage direct' on entend dans le présent document la mise en contact de deux surfaces suffisamment lisses et propres pour créer une adhérence entre elles, sans apport de matière adhésive entre les deux surfaces.

Par ailleurs, le terme 'substrat' peut aussi bien désigner une plaquette (ou wafer) massive ou composite, qu'une puce. Un procédé de collage direct tel que celui décrit ci-dessus peut s'appliquer non seulement à un collage direct entre deux substrats, comprenant ou non des dispositifs électroniques, mais également à un collage direct entre un substrat et une puce ou à un collage direct entre deux puces.

La température du traitement thermique étant inférieure à 600°C, ce procédé est compatible avec la présence de composant CMOS dans le premier substrat.

De préférence, l'étape b) est réalisée de sorte à former un alliage de type MWxOy avec une teneur atomique du troisième élément M comprise entre environ 0.5 et 20 %. Il est entendu que le troisième élément M peut être présent sous forme oxydée dans l'alliage.

Avantageusement, le collage direct selon l'étape b) de la présente invention est réalisé par la mise en contact des couches de collage à température ambiante.

Le collage direct selon l'étape b) est par ailleurs réalisé à pression atmosphérique.

Le procédé de collage de la présente invention est ainsi facile à mettre en oeuvre et peu coûteux. Il n'est pas même nécessaire d'appliquer une pression uniaxiale de part et d'autre de l'assemblage formé du premier substrat collé au deuxième substrat afin de renforcer l'énergie de collage.

Selon une disposition, le troisième élément M est choisi parmi les éléments des lignes 1 à 6 et des colonnes 1 à 17 du tableau périodique.

Avantageusement, le troisième élément M est choisi parmi les métaux de transition et leur combinaison de sorte à favoriser la conductivité électrique au sein de l'oxyde de tungstène. Ainsi, la conduction électrique verticale entre le premier substrat et le deuxième substrat est améliorée.

De préférence, le troisième élément M est choisi parmi le Ti, Y, V, Cr, Mn, Fe, Co, Ni, Cu, Zn, Mo, Ru, Pd, Ag, Hf, Ta, Ir, Pt et Au et leur combinaison, de sorte à former un alliage compatible avec une utilisation en microélectronique. Ces matériaux sont conducteurs électriques et ne risquent pas de contaminer les matériaux des substrats ou d'endommager les composants électroniques.

Selon une possibilité, le troisième élément M est un élément oxydé parmi les éléments précédemment cités.

Dans la présente demande, par l'expression 'composants électroniques', on entend aussi bien des composants complexes tels que des CMOS, des mémoires, que des composants simples telle qu'une interconnexion électrique. Les composants électroniques peuvent être réalisés de façon préalable au collage direct par des procédés microélectroniques incluant de façon non exhaustive des étapes de gravure, de dépôt, de nettoyage ou autres.

Selon une disposition, la première couche de collage et la deuxième couche de collage présentent indépendamment l'une de l'autre une épaisseur comprise environ entre 5 et 50 nanomètres.

Selon une possibilité, la formation de la première couche de collage et la deuxième couche de collage selon l'étape b) comprend la formation d'un oxyde de tungstène suivi de l'incorporation du troisième élément M à l'oxyde de tungstène.

Typiquement, la formation de l'oxyde de tungstène comprend un dépôt par voie chimique, tel que par CVD.

Selon une variante, la formation de l'oxyde de tungstène comprend une oxydation native, oxydation sèche ou oxydation humide d'une région superficielle d'une première couche de tungstène et d'une deuxième couche de tungstène respectivement formées au préalable respectivement sur le premier substrat et le deuxième substrat.

Selon une possibilité, le troisième élément M est incorporé à l'oxyde de tungstène par diffusion ionique.

Selon une variante, le troisième élément M est incorporé à l'oxyde de tungstène par implantation ionique.

Selon une autre variante, la au moins une parmi la première couche de collage et la deuxième couche comportant le troisième élément M est formée par un dépôt par co-pulvérisation réactive de tungstène et du troisième élément M, sous un plasma comprenant une quantité déterminée d'oxygène gazeux. Par l'expression 'co-pulvérisation réactive', également connue sous l'expression anglo-saxonne « reactive co-sputtering », on entend dans le présent document une pulvérisation simultanée de deux éléments sous un plasma comprenant une espèce réactive, c'est à dire réagissant avec au moins l'un des deux éléments pulvérisés. Ainsi, cette alternative de dépôt par PVD (acronyme anglo-saxon de Physical Vapor Déposition) permet la formation simultanée de l'alliage de l'oxyde de tungstène et du troisième élément M.

Selon une possibilité, la co-pulvérisation réactive est réalisée à partir d'une cible de tungstène et d'une cible du troisième élément M.

Selon une autre possibilité, le dépôt est réalisé par pulvérisation réactive à partir d'une seule cible comprenant un alliage formé de tungstène et du troisième élément M, la teneur atomique du troisième élément M dudit alliage de la cible étant comprise environ entre 0,5 et 20%.

Selon une disposition, la co-pulvérisation réactive est réalisée avec une densité surfacique de puissance appliquée sur la cible de tungstène constante à environ 2,6 W/cm2 en mode RF.

Avantageusement, le gaz inerte utilisé dans le plasma de gaz de travail est de l'argon fourni avec un débit de 50 sccm. Éventuellement, le gaz inerte peut être du xénon.

De préférence, le gaz réactif est de l'oxygène et le débit d'oxygène est compris entre 5 et 20 sccm et de préférence entre 8 et 13 sccm.

Le troisième élément M est avantageusement du molybdène, notamment oxydé en présence de l'oxygène gazeux dans le plasma d'argon.

Le plasma est en effet obtenu à partir d'argon et d'oxygène réactif, le débit relatif en oxygène et en argon est ajusté pour contrôler la quantité d'oxygène dans l'alliage.

De préférence les puissances respectives appliquées aux cibles molybdène et tungstène sont ajustées de sorte que la teneur atomique en molybdène dans l'alliage est comprise entre 1 et 10% : pour cela on choisira des conditions menant sensiblement à la même vitesse de dépôt pour le dépôt de l'oxyde de tungstène (3,36 Å/s pour une machine Alliance Concept CT200) et le dépôt de la couche obtenue par co-pulvérisation MoWxOy (comprise entre 3,39 Å/s et 3,73 Å/s pour cette même machine, la plage de densité surfacique de puissance appliquée au molybdène étant comprise entre environ 0.1 et 0.8W/cm²). En effet cette plage de teneur atomique permet de stabiliser efficacement l'alliage de la couche de collage, notamment lors du recuit de stabilisation.

Selon une disposition, le procédé comprend avant l'étape b) une étape a1) de dépôt par pulvérisation d'une première couche de tungstène et d'une deuxième couche de tungstène respectivement sur le premier substrat et le deuxième substrat, l'étape b) de dépôt par co-pulvérisation réactive de la première couche de collage et de la deuxième couche de collage étant réalisée respectivement sur la première couche de tungstène et sur la deuxième couche de tungstène dans la même enceinte que le dépôt par PVD de l'étape a1), le procédé étant dépourvu de toute étape de remise à l'air intermédiaire entre l'étape a1) et l'étape b). Ainsi, le collage obtenu entre le premier substrat et le deuxième substrat est stable et la présence des couches de tungstène dépourvu d'oxyde natif, garanti une très bonne conduction électrique verticale, ce qui est idéal pour des intégrations 3D.

De préférence, la première couche de collage et la deuxième couche de collage comprennent le troisième élément M. Ainsi, la qualité du collage direct est optimisée ainsi que sa conduction électrique et sa tenue mécanique.

D'autres aspects, buts et avantages de la présente invention apparaîtront mieux à la lecture de la description suivante d'un mode de réalisation de celle-ci, donné à titre d'exemple non limitatif et fait en référence aux dessins annexés. Les figures ne respectent pas nécessairement l'échelle de tous les éléments représentés de sorte à améliorer leur lisibilité. Dans la suite de la description, par souci de simplification, des éléments identiques, similaires ou équivalents des différentes formes de réalisation portent les mêmes références numériques.

La figure 1 est une reproduction d'un scan AFM d'une couche de collage recuite de l'art antérieur sur un champ de 4 micromètres x 4 micromètres illustrant une cristallisation dendritique de l'oxyde de tungstène.

Les figures 2 à 5 illustrent des étapes successives, selon une vue en coupe, d'un procédé de collage direct selon l'invention.

La figure 6 est une reproduction d'un scan AFM d'une couche de collage obtenue selon l'invention sur un champ de 5 micromètres x 5 micromètres.

Les figures 2 à 5 représentent des étapes successives d'un procédé de collage direct par formation d'une couche de collage à base d'oxyde de tungstène comprenant un troisième élément, que l'on peut nommer 'impureté', avec une teneur atomique compris entre 0.5 % et 20%.

Un premier substrat 1 et un deuxième substrat 2 en silicium sont tout d'abord fournis après un nettoyage chimique préalable des surfaces par l'acide de CARO et RCA (étape a) -figure 2).

Puis selon l'étape a1) une première couche mince 3 métallique de tungstène et une deuxième couche mince 4 métallique de tungstène sont formées par PVD respectivement sur le premier substrat 1 et le deuxième substrat 2 (figure 3). Le dépôt du tungstène est effectué par exemple dans un bâti de dépôt Alliance Concept CT200 à une température de 30°C, sous application sur la cible de tungstène d'une puissance de 2,6 W/cm² par unité de surface, appliquée en mode continu DC. Le plasma est à base d'argon, présent avec une pression de 1,9 mTorr et un débit d'argon de 50 sccm. Aucune tension de polarisation n'est appliquée au substrat au cours du dépôt. L'épaisseur de la première couche mince 3 de tungstène et de la deuxième couche mince 4 de tungstène est d'environ 10 nm.

Suivant l'étape b) du procédé, la formation de la première couche de collage 5 et de la deuxième couche de collage 6 respectivement sur la première couche mince 3 de tungstène et de la deuxième couche mince 4 de tungstène est réalisée par co-pulvérisation réactive de tungstène et du troisième élément de molybdène par dépôt dans le même bâti de PVD, sans étape de remise à l'air intermédiaire (c'est-à-dire sans sortir le substrat 1, 2 de l'équipement PVD) pour éviter la formation d'oxyde de tungstène natif et instable en surface des couches minces 3,4 de tungstène conductrices (figure 4). Dans ce cas, du dioxygène est incorporé dans le plasma de gaz de travail d'argon utilisé pour déposer la couche de tungstène en ouvrant une vanne d'arrivée de dioxygène pour alimenter le plasma de gaz de travail en dioxygène. La première couche de collage 5 et la deuxième couche de collage 6 de MoWxOy sont formées avec une épaisseur de 5 nanomètres chacune, selon les paramètres suivants :
La température de dépôt est de l'ordre de 30°C, aucune tension de polarisation n'est appliquée au substrat.

La source comprend deux cibles. Une cible de tungstène sur laquelle la puissance appliquée est maintenue constante à 2,6 W/cm² en mode RF, et une cible de Molybdène sur laquelle une puissance de 0,4 W/cm2 en mode RF est appliquée de sorte d'obtenir des vitesses de dépôt telles que la teneur atomique en Molybdène dans la composition de l'alliage est de 5%.

La pression dans la chambre de déposition est de 1,9 mTorr, le débit d'argon est de 50 sccm et le débit d'oxygène gazeux est de 8.8 sccm.

Selon une variante de réalisation non illustrée, la source est composée d'une seule cible comprenant directement un alliage de tungstène et de molybdène, présent avec une teneur atomique de 5%. Dans ces conditions, le dépôt de la première couche de collage 5 et de la deuxième couche de collage 6 est effectué par une seule pulvérisation réactive en présence d'oxygène.

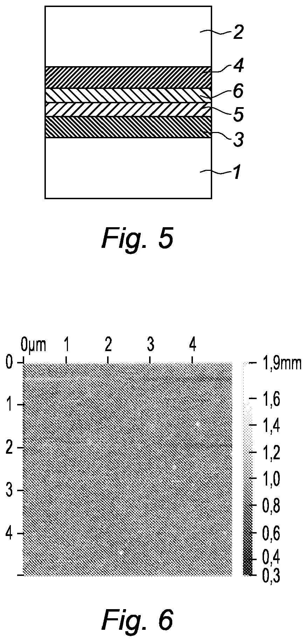

Puis, la première couche de collage 5 et la deuxième couche de collage 6 sont mises en contact pour un collage direct selon l'étape c) du procédé et un recuit de collage est effectué par l'application d'un traitement thermique réalisé à 500°C pendant une durée de 2 heures selon l'étape d). Ce recuit permet un assemblage mécaniquement stable entre le premier substrat 1 et le deuxième substrat 2 (figure 5). Aucune application de pression de part et d'autre de l'interface de collage n'est nécessaire pour renforcer l'énergie du collage.

Un amincissement mécanique et chimique est réalisé jusqu'à atteindre les couches de collage 5,6 en MoWxOy à des fins d'observations. La morphologie de ces couches de collage 5,6 est observée par microscope à force atomique (AFM) en utilisant le mode « tapping ». Elle est représentée sur le scan de la figure 6. La couche de collage 5,6 de MoWxOy comprenant une teneur atomique de 5% de molybdène est continue et ne présente pas de régions cristallisées, au contraire de la couche de collage de l'art antérieur et ne présentant pas de troisième élément (se référer au scan reproduit à la figure 1). Ainsi, le procédé de l'invention permet l'obtention de couches de collage homogènes 5,6, permettant d'assurer la conduction électrique verticale entre les deux substrats 1,2 assemblés.

Selon une variante, le procédé de l'invention est réalisé avec un traitement thermique à 600°C pendant deux heures et conduit à la même observation, que la teneur atomique estimée en molybdène de la couche de collage 5,6 soit de 2 %, 5 % ou 10% (non illustré).

Les mêmes résultats sont obtenus avec différents débits en oxygène. Toutefois, au-delà de 12,5 sccm débit, la teneur en molybdène est de préférence supérieure à 2% pour éviter tout risque de cristallisation si le traitement thermique de renforcement de collage est effectué à plus de 550°C.

Selon une alternative non illustrée, le collage du premier substrat 1 et du deuxième substrat 2 est également réalisé à partir de couches de collage 5,6 initialement formée en oxyde de tungstène et dans lesquelles un troisième élément est incorporé par implantation ou par diffusion ionique avant mise en contact.

Le troisième élément est choisi selon les propriétés souhaitées du collage et selon les applications visées. Il est par exemple sélectionné dans la liste des métaux de transition afin de favoriser la conduction électrique verticale. Il est avantageusement choisi parmi la liste de Ti, Y, V, Cr, Mn, Fe, Co, Ni, Cu, Zn, Mo, Ru, Pd, Ag, Hf, Ta, Ir, Pt et Au et leur combinaison, pour ne pas risquer de contaminer les applications dans le domaine de la microélectronique.

Selon une autre disposition non illustrée, le premier substrat 1 et le deuxième substrat 2 sont constitués de matériaux de natures différentes et choisis parmi des matériaux semi-conducteurs, des métaux ou des céramiques, recouverts ou non d'une couche mince de métal ou d'un diélectrique formant des motifs.

Ainsi, la présente invention propose un procédé de collage direct conducteur électrique et de bonne tenue mécanique malgré un recuit de collage effectuer à une température compatible avec la présence de composants électroniques. En effet, la présence d'un troisième élément ou d'une « impureté » dans le matériau de la couche de collage 5,6 à base d'oxyde de tungstène permet de stabiliser la couche et de retarder sa cristallisation qui limite la conduction électrique de l'interface de collage et limite la tenue du collage. De plus, le procédé est simple à mettre en en oeuvre, peu coûteux et rapide, l'incorporation du troisième élément pouvant être effectuée simultanément au dépôt de la couche de collage 5,6.

## Revendications

1. Procédé de collage direct entre un premier substrat (1) et un deuxième substrat (2), notamment utilisés dans l'industrie de la microélectronique, le procédé comprenant les étapes de :
a) Fournir le premier substrat (1) et le deuxième substrat (2),
b) Former une première couche de collage (5) à base d'oxyde de tungstène sur le premier substrat (1) et une deuxième couche de collage (6) à base d'oxyde de tungstène sur le deuxième substrat (2), l'une au moins parmi la première couche de collage (5) et la deuxième couche de collage (6) comportant, un troisième élément M de sorte à former un alliage de type MWxOy, la teneur atomique de M dans la composition de l'alliage étant comprise entre 0,5 et 20% et de préférence comprise entre 1 et 10%,
c) Procéder au collage direct entre la première couche de collage (5) et la deuxième couche de collage (6), et
d) Réaliser un traitement thermique à une température supérieure à 250°C.

2. Procédé selon la revendication 1, dans lequel le traitement thermique est réalisé à une température comprise entre 400° et 600°C.

3. Procédé selon l'une des revendications 1 ou 2, dans lequel le troisième élément M est choisi parmi les métaux de transition et leur combinaison, de sorte à favoriser la conduction électrique entre le premier substrat (1) et le deuxième substrat (2).

4. Procédé selon l'une des revendications 1 à 3, dans lequel le troisième élément M est choisi parmi le Ti, Y, V, Cr, Mn, Fe, Co, Ni, Cu, Zn, Mo, Ru, Pd, Ag, Hf, Ta, Ir, Pt et Au et leur combinaison, de sorte à former un alliage compatible avec une utilisation en microélectronique.

5. Procédé selon l'une des revendications 1 à 4, dans lequel la première couche de collage (5) et la deuxième couche de collage (6) présentent indépendamment l'une de l'autre une épaisseur comprise environ entre 5 et 50 nanomètres.

6. Procédé selon l'une des revendications 1 à 5, dans lequel la formation de la première couche de collage (5) et la deuxième couche de collage (6) selon l'étape b) comprend la formation d'un oxyde de tungstène suivi de l'incorporation du troisième élément M à l'oxyde de tungstène.

7. Procédé selon la revendication 6, dans lequel le troisième élément M est incorporé à l'oxyde de tungstène par diffusion ionique.

8. Procédé selon la revendication 6, dans lequel le troisième élément M est incorporé à l'oxyde de tungstène par implantation ionique.

9. Procédé selon l'une des revendications 1 à 5, dans lequel la au moins une parmi la première couche de collage (5) et la deuxième couche de collage (6) comportant le troisième élément M est formée par un dépôt par co-pulvérisation réactive de tungstène et du troisième élément M, sous un plasma comprenant une quantité déterminée d'oxygène gazeux.

10. Procédé selon la revendication 9, dans lequel la co-pulvérisation réactive est réalisée à partir d'une cible de tungstène et d'une cible du troisième élément M.

11. Procédé selon la revendication 9, dans lequel le dépôt est réalisé à partir d'une seule cible comprenant un alliage formé de tungstène et du troisième élément M, la teneur atomique du troisième élément M dudit alliage de la cible étant comprise environ entre 0,5 et 20%.

12. Procédé selon l'une des revendications 9 à 11, dans lequel le troisième élément M est du molybdène oxydé par l'oxygène gazeux présent dans le plasma.

13. Procédé selon la revendication 12, dans lequel les vitesses respectives de dépôt du molybdène et du tungstène sont ajustées de sorte que la teneur atomique en molybdène dans la composition de l'alliage est comprise entre 1 et 10%.

14. Procédé selon l'une des revendications 1 à 12, comprenant avant l'étape b) une étape a1) de dépôt par pulvérisation d'une première couche mince (3) de tungstène et d'une deuxième couche mince (4) de tungstène respectivement sur le premier substrat (1) et le deuxième substrat (2) et dans lequel l'étape b) de dépôt par co-pulvérisation de la première couche de collage (5) et de la deuxième couche de collage (6) est réalisée respectivement sur la première couche mince (3) de tungstène et sur la deuxième couche mince (4) de tungstène dans la même enceinte que le dépôt PVD de l'étape a1), le procédé étant dépourvu de toute étape de remise à l'air intermédiaire entre l'étape a1) et l'étape b).

15. Procédé selon l'une des revendications 1 à 13, dans lequel la première couche de collage (5) et la deuxième couche de collage (6) comprennent le troisième élément M.

## Patentansprüche

1. Direktverklebungsverfahren zwischen einem ersten Substrat (1) und einem zweiten Substrat (2), insbesondere in der Industrie der Mikroelektronik verwendet, wobei das Verfahren die folgenden Schritte umfasst:
a) Bereitstellen des ersten Substrats (1) und des zweiten Substrats (2),
b) Bilden einer ersten Verklebungsschicht (5) auf Wolframoxidbasis auf dem ersten Substrat (1) und einer zweiten Verklebungsschicht (6) auf Wolframoxidbasis auf dem zweiten Substrat (2), wobei mindestens eine der ersten Verklebungsschicht (5) und der zweiten Verklebungsschicht (6) ein drittes Element M beinhaltet, um eine Legierung in der Art MWxOy zu bilden, wobei der M-Atomgehalt in der Zusammensetzung der Legierung zwischen 0,5 und 20% enthalten ist und vorzugsweise zwischen 1 und 10 % enthalten ist,
c) Vornehmen der Direktverklebung zwischen der ersten Verklebungsschicht (5) und der zweiten Verklebungsschicht (6), und
d) Durchführen einer Wärmebehandlung auf einer Temperatur über 250 °C.

2. Verfahren nach Anspruch 1, wobei die Wärmebehandlung bei einer Temperatur durchgeführt wird, die zwischen 400° und 600 °C enthalten ist.

3. Verfahren nach einem der Ansprüche 1 oder 2, wobei das dritte Element M aus den Übergangsmetallen und deren Kombination ausgewählt wird, um die elektrische Leitfähigkeit zwischen dem ersten Substrat (1) und dem zweiten Substrat (2) zu fördern.

4. Verfahren nach einem der Ansprüche 1 bis 3, wobei das dritte Element M ausgewählt wird aus dem Ti, Y, V, Cr, Mn, Fe, Co, Ni, Cu, Zn, Mo, Ru, Pd, Ag, Hf, Ta, Ir, Pt und Au und deren Kombination, um eine Legierung zu bilden, die mit einer Verwendung in Mikroelektronik kompatibel ist.

5. Verfahren nach einem der Ansprüche 1 bis 4, wobei die erste Verklebungsschicht (5) und die zweite Verklebungsschicht (6) unabhängig voneinander eine Dicke aufweisen, die etwa zwischen 5 und 50 Nanometern enthalten ist.

6. Verfahren nach einem der Ansprüche 1 bis 5, wobei die Bildung der ersten Verklebungsschicht (5) und zweiten Verklebungsschicht (6) nach Schritt b) die Bildung eines Wolframoxids, gefolgt von der Einarbeitung des dritten Elements M in das Wolframoxid umfasst.

7. Verfahren nach Anspruch 6, wobei das dritte Element M durch Ionendiffusion in das Wolframoxid eingearbeitet wird.

8. Verfahren nach Anspruch 6, wobei das dritte Element M durch Ionenimplantation in das Wolframoxid eingearbeitet wird.

9. Verfahren nach einem der Ansprüche 1 bis 5, wobei die mindestens eine aus der ersten Verklebungsschicht (5) und der zweiten Verklebungsschicht (6), die das dritte Element M beinhaltet, durch eine Abscheidung durch reaktive Co-Zerstäubung von Wolfram und des dritten Elements M unter einem Plasma gebildet wird, das eine bestimmte Menge an gasförmigem Sauerstoff umfasst.

10. Verfahren nach Anspruch 9, wobei die reaktive Co-Zerstäubung aus einem Wolfram-Ziel und einem Ziel des dritten Elements M durchgeführt wird.

11. Verfahren nach Anspruch 9, wobei die Abscheidung aus einem einzigen Ziel durchgeführt wird, das eine Legierung umfasst, die aus Wolfram und dem dritten Element M gebildet wird, wobei der Atomgehalt des dritten Elements M der Legierung des Ziels etwa zwischen 0,5 und 20 % enthalten ist.

12. Verfahren nach einem der Ansprüche 9 bis 11, wobei das dritte Element M durch gasförmigen Sauerstoff oxidiertes Molybdän ist, das in dem Plasma vorhanden ist.

13. Verfahren nach Anspruch 12, wobei die jeweiligen Abscheidegeschwindigkeiten des Molybdäns und des Wolframs derart angepasst sind, dass der Atomgehalt an Molybdän in der Zusammensetzung der Legierung zwischen 1 und 10 % enthalten ist.

14. Verfahren nach einem der Ansprüche 1 bis 12, vor dem Schritt b) einen Schritt a1) zum Abscheiden durch Zerstäuben der ersten dünnen Wolfram-Schicht (3) und einer zweiten dünnen Wolfram-Schicht (4) jeweils auf dem ersten Substrat (1) und dem zweiten Substrat (2) umfassend, und wobei der Schritt b) zum Abscheiden durch Co-Zerstäubung der ersten Verklebungsschicht (5) und der zweiten Verklebungsschicht (6) jeweils auf der ersten dünnen Wolfram-Schicht (3) und auf der zweiten dünnen Wolfram-Schicht (4) in demselben Gehäuse wie die PVD-Abscheidung des Schritts a1) durchgeführt wird, wobei das Verfahren frei von jedem Zwischenlüftungsschritt zwischen dem Schritt a1) und dem Schritt b) ist.

15. Verfahren nach einem der Ansprüche 1 bis 13, wobei die erste Verklebungsschicht (5) und die zweite Verklebungsschicht (6) das dritte Element M umfassen.

## Claims

1. A method for direct bonding between a first substrate (1) and a second substrate (2), used in particular in the microelectronics industry, the method comprising the steps of:
a) Providing the first substrate (1) and the second substrate (2),
b) Forming a tungsten oxide based first bonding layer (5) over the first substrate (1) and a tungsten oxide based second bonding layer (6) over the second substrate (2), at least one among the first bonding layer (5) and the second bonding layer (6) including, a third element M so as to form MWxOy type alloy, the atomic content of M in the composition of the alloy being comprised between 0.5 and 20% and preferably comprised between 1 and 10%,
c) Proceeding with the direct bonding between the first bonding layer (5) and the second bonding layer (6), and
d) Carrying out a heat treatment at a temperature higher than 250°C.

2. The direct bonding method according to claim 1, wherein the heat treatment is carried out at a temperature comprised between 400°C and 600°C.

3. The direct bonding method according to any of claim 1 or 2, wherein the third element M is selected from transition metals and the combination thereof, so as to promote the electrical conduction between the first substrate (1) and the second substrate (2).

4. The direct bonding method according to any of claims 1 to 3, wherein the third element M is selected from Ti, Y, V, Cr, Mn, Fe, Co, Ni, Cu, Zn, Mo, Ru, Pd, Ag, Hf, Ta, Ir, Pt and Au and the combination thereof, so as to form an alloy compatible with a use in microelectronics.

5. The direct bonding method according to any of claims 1 to 4, wherein the first bonding layer (5) and the second bonding layer (6) have, independently of each other, a thickness comprised between about 5 and 50 nanometers.

6. The direct bonding method according to any of claims 1 to 5, wherein the formation of the first bonding layer (5) and the second bonding layer (6) according to step b) comprises the formation of a tungsten oxide followed by the incorporation of the third element M into the tungsten oxide.

7. The direct bonding method according to claim 6, wherein the third element M is incorporated into the tungsten oxide by ionic diffusion.

8. The direct bonding method according to claim 6, wherein the third element M is incorporated into the tungsten oxide by ionic implantation.

9. The direct bonding method according to any of claims 1 to 5, wherein the at least one among the first bonding layer (5) and the second bonding layer (6) comprising the third element M is formed by a deposition by reactive co-pulverization of tungsten and of the third element M, under a plasma comprising a determined amount of gaseous oxygen.

10. The direct bonding method according to claim 9, wherein the reactive co-pulverization is carried out from a tungsten target and from a target of the third element M.

11. The direct bonding method according to claim 9, wherein the deposition is carried out from one single target comprising an alloy formed by tungsten and by the third element M, the atomic content of the third element M of said alloy of the target being comprised between about 0.5 and 20%.

12. The direct bonding method according to any of claims 9 to 11, wherein the third element M is molybdenum oxidized by the gaseous oxygen present in the plasma.

13. The direct bonding method according to claim 12, wherein the respective rates of deposition of molybdenum and tungsten are adjusted so that the atomic content of molybdenum in the composition of the alloy is comprised between 1 and 10%.

14. The direct bonding method according to any of claims 1 to 12, comprising prior to step b) a step a1) of deposition by pulverization of a thin first layer (3) of tungsten and of a thin second layer (4) of tungsten respectively over the first substrate (1) and the second substrate (2) and wherein step b) of deposition by co-pulverization of the first bonding layer (5) and of the second bonding layer (6) is carried out respectively over the thin first layer (3) of tungsten and over the thin second layer (4) of tungsten in the same enclosure as the PVD deposition of step a1), the method being devoid of any intermediate step of returning into air between step a1) and step b).

15. The direct bonding method according to any of claims 1 to 13, wherein the first bonding layer (5) and the second bonding layer (6) comprise the third element M.
